# EUROPEAN PATENT APPLICATION

(11) **EP 2 757 864 A2**
(43) Date of publication of application: **23.07.2014**
(21) Application number: 13198761.2
(22) Date of filing: 20.12.2013
(51) Int. Cl.: H05K 1/14

(54) **Connecting system of circuit boards**

(30) Priority: 16.01.2013 JP 2013005690
(71) Applicant: FUJITSU LIMITED, Kawasaki-shi, Kanagawa 211-8588 (JP)
(72) Inventor: Kajio, Naohiko, Kawasaki-shi, Kanagawa 211-8588 (JP); Kosugi, Naofumi, Kawasaki-shi, Kanagawa 211-8588 (JP); Matsumoto, Yoshio, Kawasaki-shi, Kanagawa 211-8588 (JP)
(74) Representative: Wilding, Frances Ward

(57) **Abstract**

First and second tapered holes are provided at facing positions of the first and second circuit boards. The elastic spacer including first and second spacers is attached between them to couple the two in parallel and thereby facilitate attachment of the two to a back panel. The first spacer is provided at one end part with a tapered part which fits with the first tapered hole and the second spacer is provided at one end part with a tapered part which fits with the second tapered hole. A spring is inserted between the two spacers. The first spacer is fit in the tapered hole and fastened by a screw to the first circuit board. The second circuit board is fastened by a screw to the first spacer in a state fitting the second tapered hole over the second spacer with the second circuit board approaching the first circuit board.

## Description

### CROSS-REFERENCE TO RELATED APPLICATION

This application claims priority from, and incorporates by reference the entire disclosure of, Japanese Patent Application No. 2013-005690, filed on January 16, 2013.

### FIELD

The present application relates to a connecting system of a plurality of circuit boards in the case of attaching a plurality of printed circuit boards (hereinafter simply referred to as "circuit boards") to connectors which are mounted on a back panel which is provided inside a housing of an information system.

### BACKGROUND

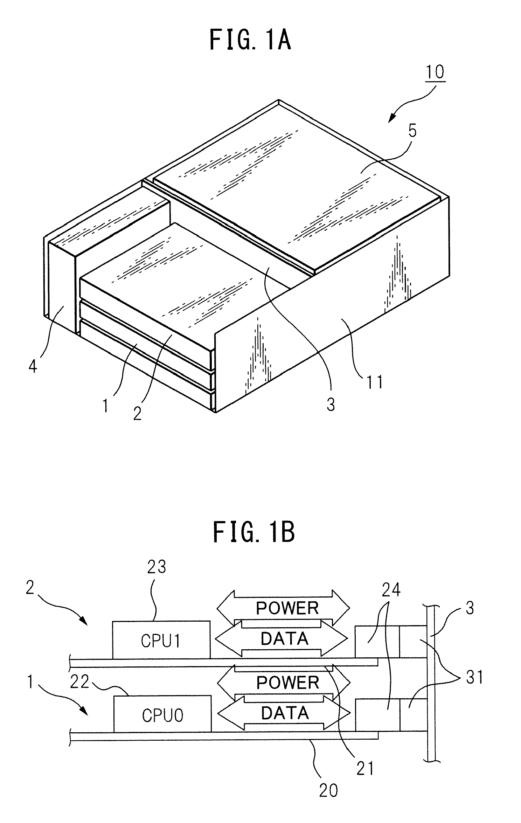

In recent years, server products have generally been equipped with a plurality of circuit boards (sometimes called "boards") which mount CPUs (central processing units) for high speed data transfer. Boards (circuit boards) on which CPUs and their peripherals are mounted are sometimes called "CPU units". FIG. 1A illustrates a server product 10 of an information system (global server). The global server 10 is provided with a housing 11 which is divided into a section which carries a hard disk, flash memory, or storage device 5, a section which carries a power unit 4, a section which carries a plurality of CPU units 1 and 2, etc. Further, the housing 11 is provided with a back panel 3 which connects different members.

The back panel 3 is arranged inside the housing 11 in the vertical direction. As illustrated in FIG. 1B, connectors 31 are attached for transfer of data with different members. The connectors 31 are connected by circuits on the back panel 3. The CPU units 1 and 2, in this example, are connected by coupling connectors 24 which are provided at the ends of the circuit boards 20 and 21 to the connectors 31 of the back panel 3 in the state with the two circuit boards 20 and 21 connected in parallel across a predetermined interval. That is, the plurality of CPU units 1 and 2 which carry CPUs 22 and 23 are connected with the back panel 3 by the connectors 24 and 31. The transfer of data and the supply of power between the CPU units and between a CPU unit and another member are performed through this back panel 3.

A system of attachment of printed circuit boards which connect such a plurality of printed circuit boards in parallel across predetermined intervals is disclosed in Japanese Examined Utility Model Application Publication No. 6-11525. For example, when connecting two printed circuit boards in parallel, as disclosed in Japanese Examined Utility Model Application Publication No. 6-11525, columnar shaped spacers which were provided with screw holes were inserted between the two printed circuit boards and the spacers were fastened by screws from the outer sides of the two printed circuit boards.

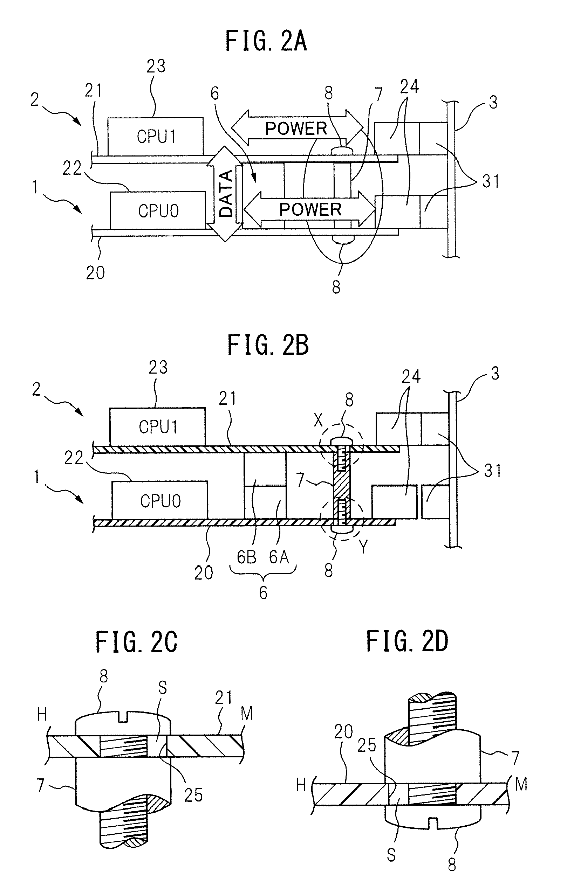

The configuration of one example in the case of applying a spacer which was disclosed in Japanese Examined Utility Model Application Publication No. 6-11525 to the CPU units 1 and 2 which are illustrated in FIG. 1B is illustrated in FIG. 2A. In this example, the spacer 7 is provided at the portion which is illustrated by the oval between the circuit boards 20 and 21 of the CPU units 1 and 2. The spacer 7 is fastened by screws 8 from the outer sides of the circuit boards 20 and 21. Further, in this example, between the circuit boards 20 and 21, a stack connector 6 is provided with the circuits of the circuit board 20 and the circuits of the circuit board 21 without going through the back panel 3.

The reason why the stack connector 6 is provided is that if transferring data of the circuit boards 20 and 21 through the back panel 3, the interconnect length becomes longer and the performance drops. If connecting the circuit boards 20 and 21 by the stack connector 6, the interconnect length near the CPUs 22 and 23 becomes shorter.

In this regard, in a system which uses a back panel to connect circuit boards, in the case of using the stack connector to connect the circuit boards, then connecting the circuit boards to the back panel, if the positioning accuracy of the connectors of the circuit boards and the connectors of the back panel is low, sometimes those connectors will not fit together or the connectors will break. This will be explained in further detail.

Up to now, in a system which uses a back panel to connect a plurality of circuit boards, the following techniques have been used in the comparative art so as to make the positioning at the time of attachment of the connectors of the circuit boards and the connectors of the back panel more accurate.
(1) Providing screw holes at the same positions of the plurality of circuit board, inserting spacers between the screw holes of the plurality of circuit boards, and using screws to fasten the spacers from the two sides to position and top and bottom circuit boards.
(2) Providing guide pins at a bottom side circuit board, providing holes at positions of the guide pins at a top side circuit board which is laid over the bottom side circuit board, and inserting the guide pins through the holes so as to position the top and bottom circuit boards.

However, with the technique of (1), if increasing the number of spacers, the positioning accuracy of the boards increases, but the work efficiency, manufacturability, and wiring ability of the circuit boards fall. Conversely, if decreasing the number of spacers, the positioning accuracy of the circuit boards fall, but the work efficiency, manufacturability, and wiring ability of the circuit boards rise, so it was difficult to achieve both in the art. Furthermore, with the technique of (1), there is a gap between the screw holes and screws for fastening the spacers on the circuit boards, so when attaching spacers between the screw holes of the circuit boards and using screws to fasten them to the circuit boards, offset ends up occurring in the positions of the top and bottom circuit boards.

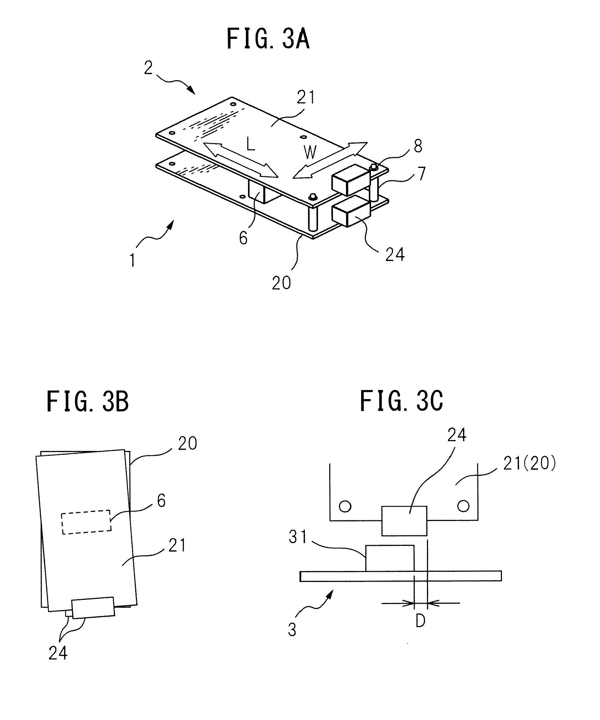

That is, as illustrated in FIG. 3A, when the top and bottom circuit boards 20 and 21 are offset in the front-back direction (arrow L direction), a gap is formed between one of the top and bottom circuit boards 20 and 21 and a connector 24, so sometimes one of the top and bottom connectors 24 will not fit with the connector of the back panel. An example where offset occurs in the positions of the top and bottom circuit boards will be illustrated in FIG. 2B to FIG. 2D. Furthermore, FIG. 2C illustrates enlarged a part X of FIG. 2B, while FIG. 2D illustrates enlarged a part Y of FIG. 2B.

Here, when inserting a screw 8 into a screw hole 25, as illustrated in FIG. 2C, sometimes the screw 8 will be biased to one side (H side) of the screw hole 25 at the top side circuit board 21 and a space S will be formed at the other side (M side). On the other hand, as illustrated in FIG. 2D, with respect to the screw hole 25 at the bottom side circuit board 20, sometimes the screw 8 will be biased to the other side (M side) and a space will be formed at the one side (H side). This being so, in this case, the top side circuit board 21 will shift from the bottom side circuit board 22 by exactly a length of two times the length of the space S in the M direction. As a result, as illustrated in FIG. 2B, the connector 24 at the top side circuit board 21 can engage with the connector 31 at the back panel 3, but the connector 24 at the bottom side circuit board 20 can no longer engage with the connector 31 at the back panel 3.

Further, when the top and bottom circuit boards 20 and 21 are offset in the left-right direction which is illustrated in FIG. 3A (arrow W direction), the connectors 24 of the top and bottom circuit boards 20 and 21 will be offset from each other, so as illustrated in FIG. 3C, one of the top and bottom connectors 24 will not fit with the connector 31 of the back panel. FIG. 3C illustrates the case where one of the top and bottom connectors 24 is offset from the connector 31 of the back panel by exactly the distance D. Furthermore, as illustrated in FIG. 3B, even when the connectors 24 of the top and bottom circuit boards 20 and 21 become offset in position due to rotating about the stack connector 6, one of the top and bottom connectors 24 will not fit with the connector 31 of the back panel. Further, if forcibly connecting one of the top and bottom connectors 24 to a connector 31 of the back panel, the connectors 24 and 31 will sometimes break.

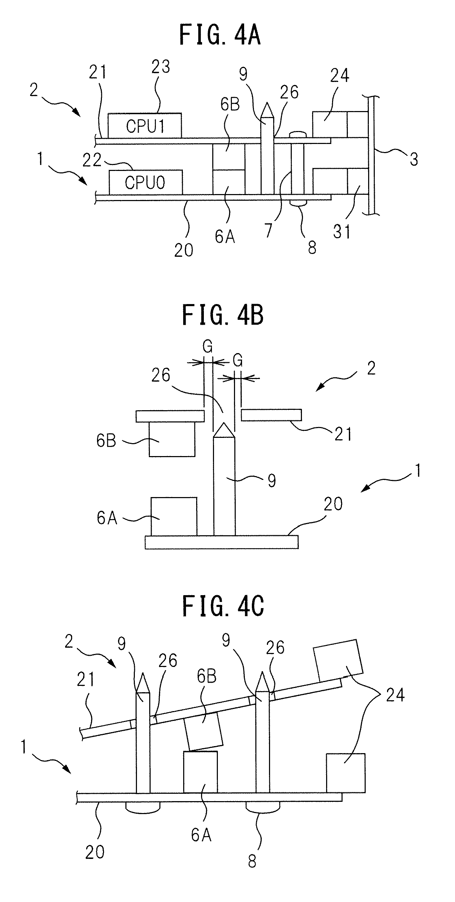

On the other hand, with the technique of (2), as illustrated in FIG. 4A, when connecting the top and bottom circuit boards 20 and 21 in parallel by a spacer 7 and screws 8, the guide pin 9 which is provided at the bottom side circuit board 20 is passed through a guide hole 26 which is provided at the top side circuit board 21 and thereby prevents offset. In this regard, as illustrated in FIG. 4B, there is a gap G for absorbing part error between the guide pin 9 and the guide hole 26. The gap G is generally 0.1 mm or so. For this reason, in the worst case, as illustrated in FIG. 4C, the top side circuit board 21 will end up being slanted with respect to the bottom side circuit board 20 and the bottom side stack connector 6A and top side stack connector 6B are liable to become hard to connect.

### SUMMARY

In one aspect, the present application has as its object the provision of a connecting system of circuit boards which can use fewer screws to fasten a plurality of circuit boards which are positioned in the up-down direction and which can improve the work efficiency, manufacturability, and wiring ability of the circuit boards and improve the positioning accuracy of the top and bottom circuit boards.

According to one aspect of the embodiments, there is provided a connecting system of circuit boards which connects a plurality of circuit boards in parallel, wherein the connecting system of circuit boards is provided with first and second tapered holes which are provided at facing positions of first and second circuit boards and an elastic spacer with two ends which are fit into the first and second tapered holes, the elastic spacer is provided with a first spacer which is provided at one end with a tapered part which is provided with a taper angle the same as the taper angle of the first tapered hole, a second spacer which is provided at one end with a tapered part which is provided with a taper angle the same as the taper angle of the second tapered hole and which engages at the other end with the first spacer and can move in the axial direction of the first spacer, and an elastic member which is attached between the first and second spacers, and the first and second spacers are provided with through holes of the same inside diameter in the axial directions.

### BRIEF DESCRIPTION OF DRAWINGS

FIG. 1A is a perspective view which illustrates one example of the configuration of an information system at which the printed connecting system of circuit boards of the present application is employed.
FIG. 1B is a view which explains connection between a CPU0 and CPU1 unit and a back panel which are illustrated in FIG. 1A.
FIG. 2A is a view which explains an existing method of connection between circuit boards of a CPU0 and CPU1 units which are illustrated in FIG. 1B.
FIG. 2B is a view which illustrates points for improvement in the existing method which is illustrated in FIG. 2A.
FIG. 2C is a cross-sectional view which illustrates details of a part X of FIG. 2B.
FIG. 2D is a cross-sectional view which illustrates details of a part Y of FIG. 2B.
FIG. 3A is a perspective view which explains a direction of offset which occurs between two boards when connecting circuit boards of a CPU0 and CPU1 unit by a stack connector.
FIG. 3B is a view which explains trouble when a top side circuit board rotates with respect to a bottom side circuit board when connecting circuit boards of the CPU0 and CPU1 unit by a stack connector.
FIG. 3C is an explanatory view which illustrates offset of position of a coupling connector which is provided at a top side circuit board and a coupling connector which is arranged at a back panel due to the trouble which is illustrated in FIG. 3B.
FIG. 4A is a view which explains a positioning technique in which a guide pin for preventing offset of a top side circuit board with respect to a bottom side circuit board is provided at an existing method of connecting circuit boards of the CPU0 and CPU1 units which are illustrated in FIG. 2A.
FIG. 4B is a partial enlarged cross-sectional view of a guide pin portion of FIG. 4A.
FIG. 4C is an explanatory view which explains the trouble which can occur when guide pins are used for connection of circuit boards of the CPU0 and CPU1 units.
FIG. 5A is a perspective view which illustrates a tapered hole on a circuit board and an elastic spacer which form the connecting system of circuit boards of the present application.
FIG. 5B is a cross-sectional view of the elastic spacer which is illustrated in FIG. 5A.
FIG. 5C is a partial cross-sectional view which illustrates the state where the elastic spacer which is illustrated in FIG. 5B is attached to a tapered hole on a circuit board.
FIG. 5D is a partial cross-sectional view which illustrates the state where the elastic spacer which is illustrated in FIG. 5B is attached to a tapered hole on a circuit board and screwed in.
FIG. 5E is a partial cross-sectional view which illustrates the state of use of the elastic spacer which is illustrated in FIG. 5B to attach circuit boards at the top and bottom.
FIG. 6A is a view which illustrates the state of making a top side circuit board approach a bottom side circuit board to which an elastic spacer is attached.
FIG. 6B is a view which illustrates the state where the top side tapered part of the elastic spacer is fit with the tapered hole of the top side circuit board from the state which is illustrated in FIG. 6A.
FIG. 6C is a view which illustrates the state where the top side circuit board is moved to the bottom side circuit board side and the stack connector is connected from the state which is illustrated in FIG. 6B.
FIG. 6D is a view which illustrates the state where the top side circuit board in the state which is illustrated in FIG. 6C is fastened by a screw to the elastic spacer.
FIG. 7A is a plan view of an existing bottom side circuit board at which a guide pin fastening hole is provided.
FIG. 7B is a plan view of an existing top side circuit board at which a positioning hole for a guide pin is provided.
FIG. 7C is a plan view of a bottom side circuit board of the present application at which two tapered holes (alignment holes) are provided.
FIG. 7D is a plan view of a top side circuit board of the present application at which two tapered holes (alignment holes) are provided.
FIG. 8 is a table which compares the amounts of offset of coupling connectors when arranging existing circuit boards which are illustrated in FIG. 7A and FIG. 7B in parallel using guide pins and when arranging circuit boards of the present application which are illustrated in FIG. 7C and FIG. 7D in parallel using elastic spacers.
FIG. 9 is a side view, seen from the side, of the state where circuit boards of the present application which are illustrated in FIG. 7C and FIG. 7D are arranged in parallel using elastic spacers.
FIG. 10 is a side view which illustrates an embodiment where a connecting system of circuit boards which uses the elastic spacer of the first embodiment of the present application is set between three circuit boards.
FIG. 11A is a side view which illustrates a specific example of two circuit boards which corresponds to the state of FIG. 6A.
FIG. 11B is a side view which illustrates enlarged a portion with an elastic spacer, stack connector, and coupling connector of FIG. 11A.
FIG. 12A is a side view which illustrates a specific example of two circuit boards which corresponds to the state of FIG. 6B.
FIG. 12B is a side view which illustrates enlarged a portion with an elastic spacer, stack connector, and coupling connector of FIG. 12A.
FIG. 13A is a side view which illustrates a specific example of two circuit boards which corresponds to the state of FIG. 6C.
FIG. 13B is a side view which illustrates enlarged a portion with an elastic spacer, stack connector, and coupling connector of FIG. 13A.
FIG. 14A is a cross-sectional view which illustrates the configuration of a second embodiment of the elastic spacer of the present application.
FIG. 14B is a cross-sectional view which illustrates the state where the elastic spacer which is illustrated in FIG. 14A is compressed.
FIG. 14C is a cross-sectional view which illustrates the configuration of a first modification of a second embodiment of an elastic spacer of the present application.
FIG. 14D is a cross-sectional view which illustrates the configuration of a second modification of a second embodiment of an elastic spacer of the present application.

### DESCRIPTION OF EMBODIMENTS

Below, embodiments of the present application will be explained in detail based on detailed examples. Note that, for simplifying the explanation, members the same as members which are used in the techniques of the comparative art which were explained from FIG. 2A to FIG. 4C will be assigned the same reference notations for giving the explanation.

The connecting system of circuit boards of the present application connects in parallel circuit boards 20 and 21 at CPU units 1 and 2 (see FIG. 1B) at an information system which is illustrated in FIG. 1A comprised of a server product (global server) 10. In the embodiments which are explained below, first a connecting system which connects two circuit boards on which CPUs are mounted will be explained.

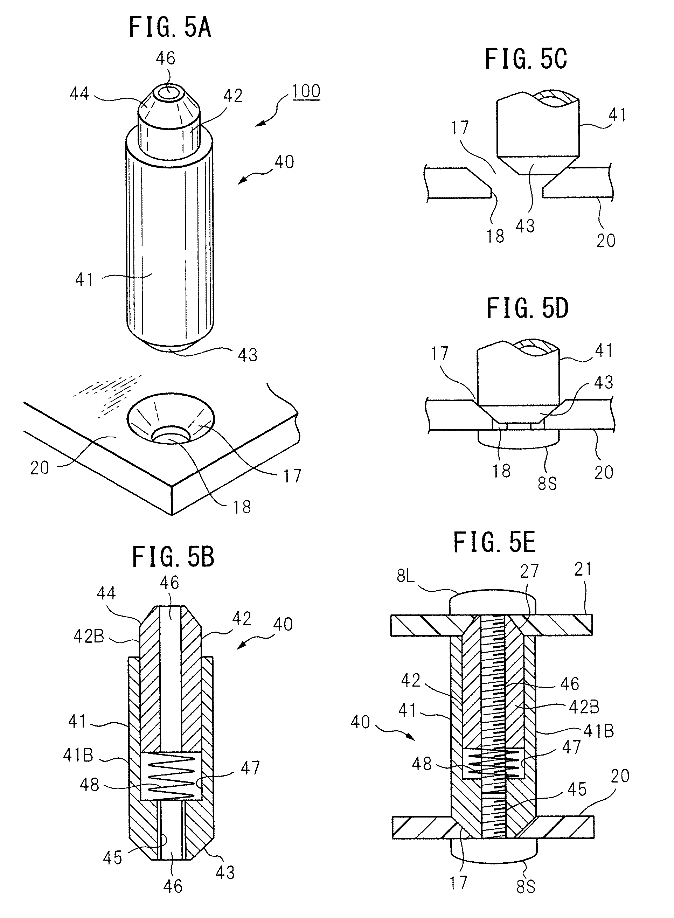

FIG. 5A illustrates part which forms the connecting system 100 of printed circuit boards of the present application such as a first tapered hole 17 which is provided at a first circuit board 20 and an elastic spacer 40 of a first embodiment. FIG. 5A does not illustrate the second circuit board and the second tapered hole which is provided at the second circuit board. The first tapered hole 17 is formed on the first circuit board 20. In this embodiment, at the bottom of the first tapered hole 17, a bottom hole 18 is formed, but depending on the thickness of the first circuit board 20, sometimes a bottom hole 18 is not provided. Tapered holes recently can be made with depth precision and can be made with accurate taper angles - which illustrate the degrees of flare of the tapers.

The elastic spacer 40 is provided with a first spacer 41 and a second spacer 42 which can move with respect to the first spacer 41 in the axial direction. The end part of the first spacer 41 at the first circuit board 20 side has a first tapered part 43 which is formed with a taper angle the same as the first tapered hole 17. Similarly, the end part of the second spacer 42 at the not illustrated second circuit board side has a second tapered part 44 which is similarly formed with a taper angle the same as the tapered hole which is formed at the second circuit board. Further, the second spacer 42 is provided with a through hole 46 in the axial direction. This through hole 46 is explained later, but is also provided at the first spacer 41 as well.

FIG. 5B illustrates a cross-section of an elastic spacer 40 which is illustrated in FIG. 5A. The first spacer 41 is provided with a first tapered part 43 which is provided with a taper angle which is the same as the taper angle of the first tapered hole 17 which is provided at the first circuit board 20. It is provided with a holding hole 47 which holds the second spacer 42 in the main body 41B. The inside diameter of the holding hole 47 is formed slightly larger than the outside diameter of the second spacer 42. The second spacer 42 is designed to be able to slide inside the holding hole 47. At the first tapered part 43 side of the holding hole 47, the through hole 46 which continues down to the end part of the first spacer 41 is formed. At the inner circumferential surface of the through hole 46, a thread 45 is formed.

The second spacer 42 has a second tapered part 44 at one end. A main body 42B which continues from the second tapered part 44 is inserted in the holding hole 47 of the first spacer 41. Further, the second spacer 42 has a through hole 46. This through hole 46 matches with the through hole 46 which is provided at the above-mentioned first spacer 41 in inside diameter and axis. Further, inside the holding hole 47 of the first spacer 41, as an elastic member which abuts against the end part of the second spacer 42, a compression spring 48 is provided. Therefore, the main body 42B of the second spacer 42 sinks into the holding hole 47 of the first spacer 41 against the compression spring 48 when pushed by external force which is applied from the second tapered part 44 side and is pushed out from the holding hole 47 by the compression spring 48 when the external force is removed.

The elastic spacer 40 which is formed in the above way is designed so that the first tapered part 43 of the first spacer 41 fits into the first tapered hole 17 at the first circuit board 20. At this time, even if the axis of the first tapered part 43 of the first spacer 41, as illustrated in FIG. 5C, does not match the axis of the first tapered hole 17, the inclination of the first tapered hole 17 causes the first tapered part 43 to slide against the slanted surface whereby the axes of the two match (center correction function of taper). As a result, as illustrated in FIG. 5C, the first tapered part 43 of the first spacer 41 fits into the first tapered hole 17 with a high precision. For this reason, when screwing in the first spacer 41 from the back surface side of the first circuit board 20 by the screw 8S, the axis of the screw 8S is positioned at the center of the first tapered hole 17.

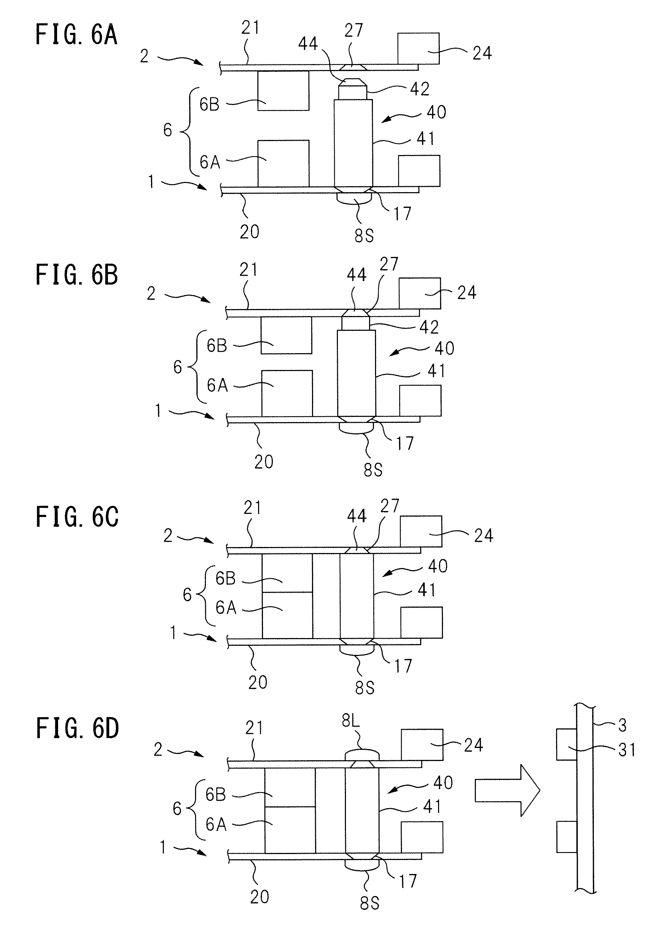

FIG. 5E illustrates the state of using the elastic spacer 40 which is illustrated in FIG. 5B to connect a bottom side circuit board 20 and a top side circuit board 21. The steps for changing from the state which is illustrated in FIG. 5D to the state which is illustrated in FIG. 5A are illustrated in FIG. 6A to FIG. 6D. As illustrated in FIG. 5D, after the first spacer 41 is attached to the first circuit board 20 by the screw 8S, as illustrated in FIG. 6A, the second tapered hole 27 of the second circuit board 21 is positioned so as to be at a position directly above the second spacer 42. Note that, in this embodiment, the first and second circuit boards 20 and 21 have stack connectors 6A and 6B mounted on them.

Next, as illustrated in FIG. 6B, the second tapered hole 27 of the second circuit board 21 is fit over the second tapered part 44 of the second spacer 42. At this time, even if the second tapered hole 27 and the second tapered part 44 are a little offset, as explained in FIG. 5C and FIG. 5D, the inclined surfaces of the two enable the second tapered hole 27 of the second circuit board 21 to accurately fit over the second tapered part 44 of the second spacer 42. Next, as illustrated in FIG. 6C, the second circuit board 21 is pushed to the first circuit board 20 side to compress the elastic spacer 40 and connect the stack connector 6B at the second circuit board 21 to the stack connector 6A at the first circuit board 20. The distance between the stack connector 6A and the first tapered hole 17 and the distance between the stack connector 6B and the second tapered hole 27 are the same. The second spacer 42 moves in the vertical direction with respect to the first spacer 41, so the stack connectors 6A and 6B are smoothly connected.

After the stack connectors 6A and 6B are connected, as illustrated in FIG. 6D, the screw 8L is inserted from the second circuit board 21 side to the elastic spacer 40 to fasten the elastic spacer 40. This state is the state which is illustrated in FIG. 5E. The thread 45 is provided at the through hole 46 at the first spacer 41, so the screw 8S which is inserted from the first circuit board 20 side is short. The screw 8L which is inserted from the second circuit board 21 side is provided with a length which passes through the through hole 46 of the second spacer 42 and reaches the thread 45. After this, the screw 8L will be called the "long screw 8L". At this time, if the total length of the stack connector 6 and the height of the end part of the first spacer 41 which is fastened to the first circuit board 20 to the first circuit board 20 are made to match, if using the long screw 8L to fasten the elastic spacer 40 to the second circuit board 21, the first and second circuit boards 20 and 21 become parallel. Accordingly, the coupling connectors 24 which are mounted at the end parts of the first and second circuit boards 20 and 21 also become parallel and can be smoothly inserted into the coupling connectors 31 which are mounted in parallel at the back panel 3.

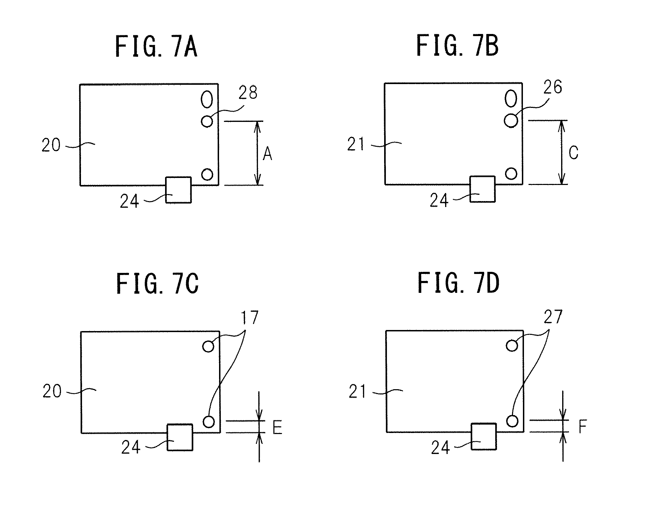

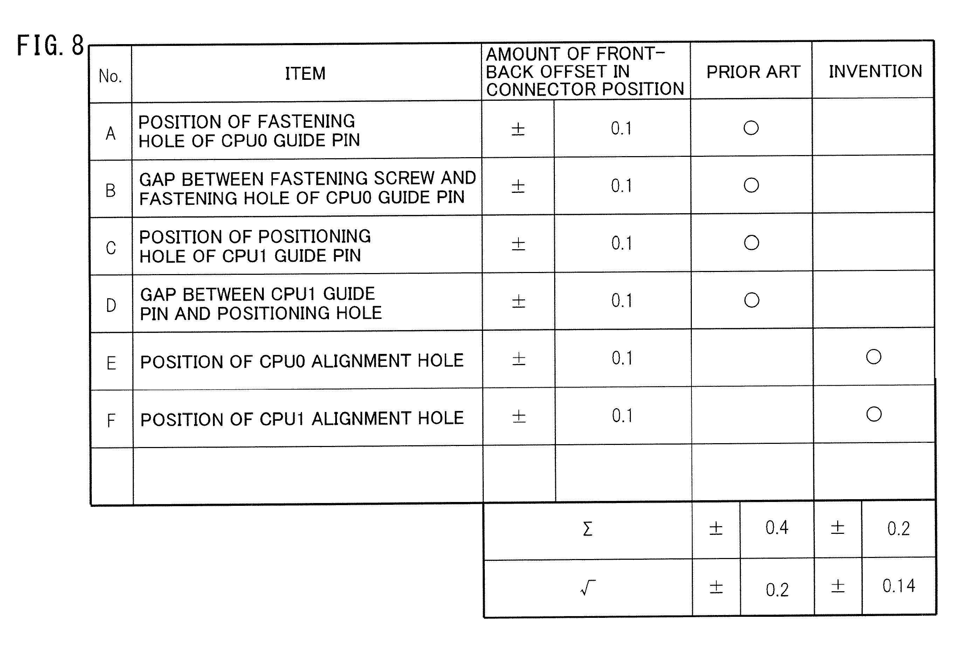

Here, the positioning precision of the front-back and left-right positions of the first and second circuit boards 20 and 21 in the case of using the guide pin 9 which is illustrated in FIG. 4A and the positioning precision of the front-back and left-right positions of the first and second circuit boards 20 and 21 in the case of using the elastic spacer of the present application will be explained by FIG. 7A to FIG. 7D and FIG. 8. FIG. 7A is a plan view of an existing bottom side circuit board (first circuit board) 20 at which a guide pin fastening hole 28 is provided, while FIG. 7B is a plan view of an existing top side circuit board (second circuit board) 21 at which a positioning hole (guide hole) 26 of the guide pin 9 is provided. At the first and second circuit boards 20 and 21, only the mounting positions of the coupling connectors 24 are otherwise illustrated. Reference notation A which is illustrated in FIG. 7A is the distance from the side of the first circuit board 20 where the coupling connector 24 is provided to the center of the guide pin fastening hole 28. Further, reference notation C which is illustrated in FIG. 7B is the distance from the side of the first circuit board 20 where the coupling connector 24 is provided to the center of the guide hole 26.

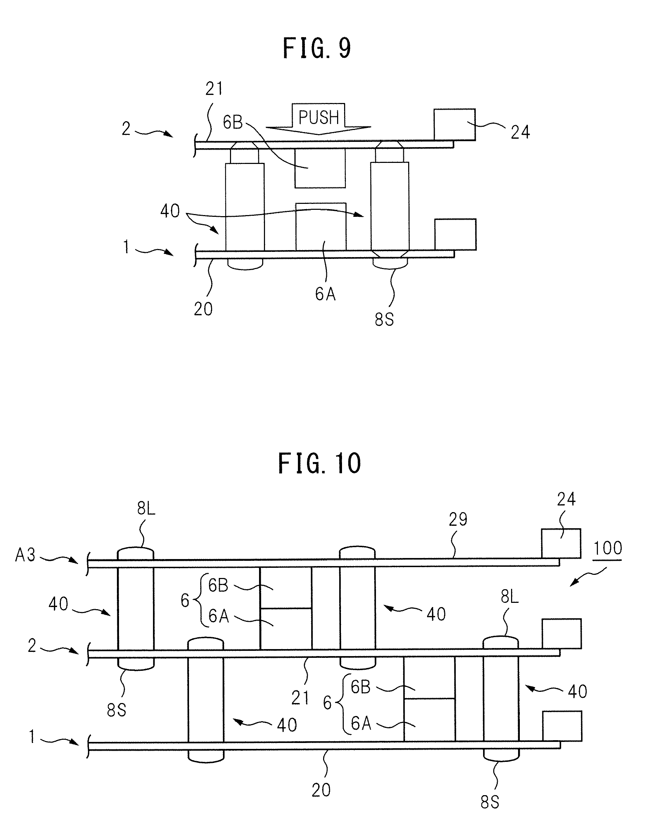

Further, FIG. 7C is a plan view of a first circuit board 20 of the present application at which two first tapered holes (alignment holes) 17 are provided, while FIG. 7D is a plan view of a second circuit board 21 of the present application at which two second tapered holes (alignment holes) 2 are provided. In this example, the first and second circuit boards 20 and 21, as illustrated in FIG. 9, are provided with two elastic spacers 40 straddling the stack connectors 6A and 6B (not illustrated in FIG. 7C and FIG. 7D). If using two elastic spacers 40, it is possible to suppress tilting of the two circuit boards before connecting the stack connectors. If using two elastic spacers 40, the first and second circuit boards 20 and 21 are respectively provided at two locations with first and second tapered holes 17 and 27. Reference notation E which is illustrated in FIG. 7C is the distance from the side of the first circuit board 20 where the coupling connector 24 is provided to the center of the first tapered hole 17. Further, reference notation F which is illustrated in FIG. 7D is the distance from the side of the second circuit board 21 where the coupling connector 24 is provided to the center of the second tapered hole 27.

FIG. 8 compares the amount of offset of the coupling connectors at the time of connecting the first and second circuit boards 20 and 21 which are illustrated in FIG. 7A and FIG. 7B by using a guide pin and the time of connecting the first and second circuit boards 20 and 21 of the present application which are illustrated in FIG. 7C and FIG. 7D by using an elastic spacer. The numerical values which are illustrated indicate the amounts of offset in the short direction (front-back direction) of the first and second circuit boards 20 and 21, but the amounts of offset in the long direction (left-right direction) are similar. Note that, FIG. 8 describes the first circuit board as the "CPU0" and describes the second circuit board as the "CPU1".

Referring to FIG. 8, in the comparative art, the position of the fastening hole of the guide pin of the CPU0, the gap between the fastening screw and the fastening hole of the guide pin, the position of the positioning hole of the guide pin of the CPU1, and the gap between the guide pin and the positioning hole have amounts of front-back offset of ±0.1 mm. For this reason, in the first and second circuit boards 20 and 21 of the comparative art, a maximum ±0.4 mm amount of offset occurs. As opposed to this, in the present application, no offset occurs between the first and second tapered holes (in FIG. 7, described as alignment holes) 17 and 27 and the elastic spacer 40, so the amount of offset is only the offset of the positions of the first and second tapered holes 17 and 27. Accordingly, in the first and second circuit boards 20 and 21 of the present application, as the amount of front-back offset, only a maximum ±0.2 mm amount of offset occurs. The positioning precision of the first and second circuit boards 20 and 21 is improved and the breakage of coupling connectors which connect the first and second circuit boards to the back panel is reduced. Further, this is also effective when using a small sized connector with a short effective engagement length when saving space by high density mounting.

The embodiments which were explained above are connecting systems of circuit boards between first and second circuit boards 20 and 21, but the connecting system of circuit boards of the present application can also be applied to the case of three or more circuit boards. FIG. 10 is a side view which illustrates an embodiment where the connecting system 100 of circuit boards which uses the elastic spacer 40 of the first embodiment of the present application is provided between three circuit boards 20, 21, and 29. In this embodiment, elastic spacers 40 are set straddling the stack connector 6 between the circuit boards 20 and 21, while elastic spacers 40 are set straddling the stack connector 6 between the circuit boards 21 and 29 as well. Further, the positions of the stack connectors 6 and elastic spacers 40 do not overlap in the top-bottom direction. In this way, when the number of circuit boards increases, it is sufficient to keep the set positions of the elastic spacers 40 from overlapping in the top-bottom direction.

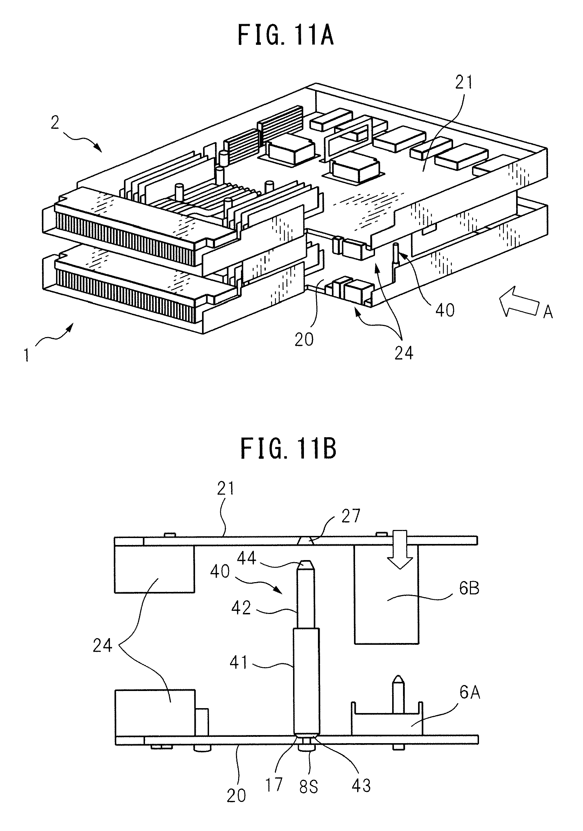

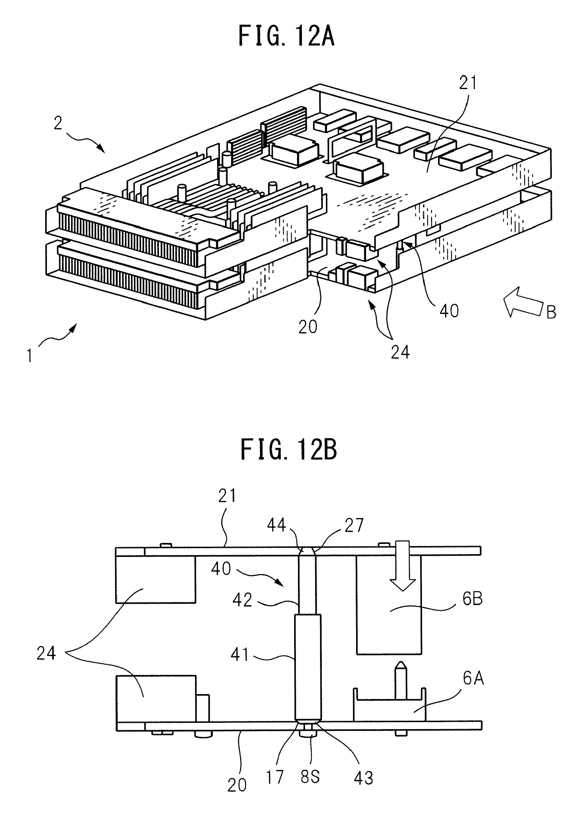

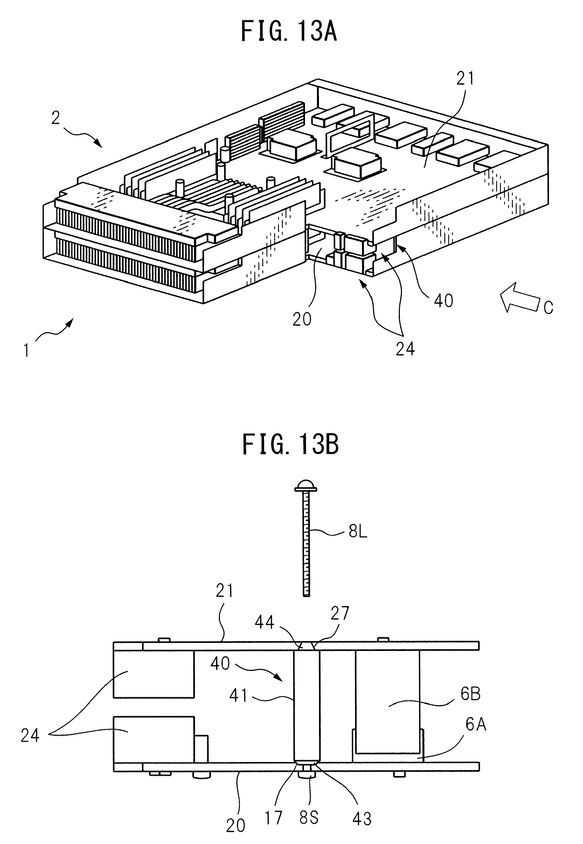

Next, specific examples to which the connecting system of circuit boards of the present application is applied will be illustrated from FIG. 11A to FIG. 13B. FIG. 11A and FIG. 11B are a perspective view and a side view which correspond to the state of FIG. 6A, FIG. 12A and FIG. 12B are a perspective view and a side view which correspond to the state of FIG. 6B, and FIG. 13A and FIG. 13B are a perspective view and a side view which correspond to the state of FIG. 6C. Note that, in FIG. 11A to FIG. 13B, component members the same as the component members which are illustrated in FIG. 6A to FIG. 6D are assigned the same reference notations.

FIG. 11A and FIG. 11B illustrate the state where the second tapered hole 27 of the second circuit board 21 is positioned right above the second spacer 42 and illustrates the state where the elastic spacer 40 is fastened to the first circuit board 20. In this state, the second tapered hole 27 of the second circuit board 21 is still not connected to the elastic spacer 40. After this, the second circuit board 21 is made to move in the direction of the arrow mark which is illustrated in FIG. 11B.

FIG. 12A and FIG. 12B illustrate the state where the second tapered hole 27 of the second circuit board 21 is fit over the second tapered part 44 of the second spacer 42. In this state, the stack connector 6A at the first circuit board 20 and the stack connector 6B at the second circuit board 21 are still not connected. After this, the second circuit board 21 is made to move in the direction of the arrow mark which is illustrated in FIG. 12B whereby the stack connector 6A and the stack connector 6B are connected.

FIG. 13A and FIG. 13B illustrate the state where the stack connector 6A at the first circuit board 20 and the stack connector 6B at the second circuit board 21 are connected. After this, the long screw 8L is inserted from outside the second circuit board 21 into the through hole of the second spacer 42 and screwed into the first spacer 41 whereby the elastic spacer 40 is fastened to the second circuit board 21.

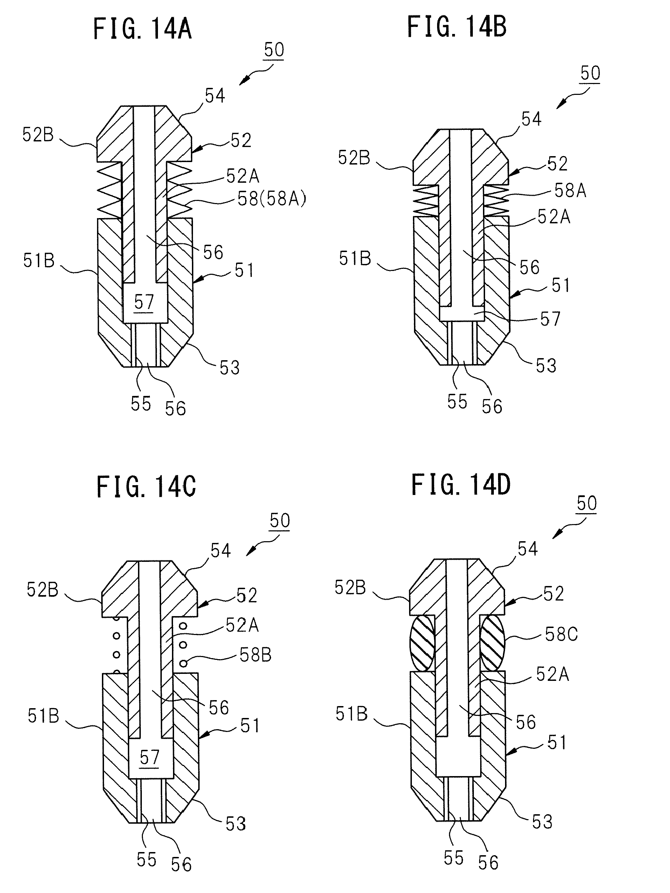

FIG. 14A illustrates the configuration of the elastic spacer 50 of the second embodiment of the present application. The elastic spacer 50 of the second embodiment is provided with a first spacer 51, second spacer 52, and elastic member 58 which is provided between the first and second spacers 51 and 52. The main bodies 51B and 52B of the first and second spacers 51 and 52 are provided with the same outside diameters. The first and second tapered parts 53 and 54 which are provided at the end parts of the first and second spacers 51 and 52 are provided with the same taper angles. Therefore, the first tapered hole which is formed at the first circuit board which is connected by the elastic spacer 50 and the second tapered hole which is formed at the second circuit board may also be the same in taper angle. Note that, the second spacer 52 may also have the main body 52B omitted and be provided with just the second tapered part 54.

At the first spacer 51 side of the main body 52B of the second spacer 52, a constricted diameter rod part 52A is provided. The second tapered part, main body 52B, and rod part 52A are provided with through holes 56 which pass through them. On the other hand, the first spacer 51 is provided at the main body 51B with a holding hole 57 which holds the rod part 52A. The outside diameter of the holding hole 57 is slightly larger than the outside diameter of the rod part 52A, while the rod part 52A can slide inside the holding hole 57 in the axial direction. Further, at the first tapered part 53 side of the holding hole 57, a through hole 56 is provided which runs through the main body 51B of the first spacer 51 and is made the same in axis as the through hole 56 which is provided at the second spacer 52 which is inserted in the holding hole 57. The through hole 56 which is provided at the first spacer 51 is formed with a thread 55. Furthermore, at the outer circumferential part of the rod part 52A, an elastic member 58 is provided which contracts when the rod part 52A sinks into the holding hole 57.

The elastic member 48 which is illustrated in FIG. 14A is an accordion like bellows 58a in this embodiment and is formed by rubber or a plastic. Due to this bellows 58A, in a state where there is no external force, the first spacer 51 and the second spacer 52 hold a predetermined length, but if an external force directed toward the first spacer 51 is applied to the second spacer 52, the bellows 58A contracts as illustrated in FIG. 14B. The elastic member 58, as in the modification which is illustrated in FIG. 14C, may be made a compression spring 58B and, as in the other modification which is illustrated in FIG. 14D, may be made a rubber ring 58C. The operation of the elastic spacer 50 in the second embodiment is similar to the elastic spacer 40 in the first embodiment, so a further explanation will be omitted.

The elastic spacer in the embodiments which were explained above enables a two-layer structure of the first spacer and second spacer to be formed without looseness. Further, between the first and second spacer, a spring member is provided. If external force directed to the first spacer side is applied to the second spacer, the second spacer contracts straight along the holding hole. Further, if the facing surfaces of the two boards at which an elastic spacer is attached are provided with tapered holes equal in taper angle with the first and second tapered parts, the elastic spacer serves as a guide before connection of the stack connector and the stack connector can be smoothly connected. Furthermore, due to the center correction function of the taper due to the tapered holes which are provided at the circuit board side and the first and second tapered parts which are provided at the two ends of the elastic spacer, the first and second tapered holes and the first and second tapered parts match in center positions and the two circuit boards can be positioned with a high precision in the front-back and left-right directions.

Although only some exemplary embodiments of this invention have been described in detail above, those skilled in the art will readily appreciated that many modifications are possible in the exemplary embodiments without materially departing from the novel teachings and advantages of this invention. Accordingly, all such modifications are intended to be included within the scope of this invention.

## Claims

1. A connecting system of circuit boards (100) which connects a plurality of circuit boards (20, 21) in parallel, wherein
said connecting system of circuit boards is provided with
first and second tapered holes (17, 27) which are provided at facing positions of first and second circuit boards (20, 21) and
an elastic spacer (40) with two ends which are fit into said first and second tapered holes (17, 27),
said elastic spacer (40) is provided with
a first spacer (41) which is provided at one end with a tapered part (43) which is provided with a taper angle the same as the taper angle of said first tapered hole (17),
a second spacer (42) which is provided at one end with a tapered part (44) which is provided with a taper angle the same as the taper angle of said second tapered hole (27) and which engages at the other end with said first spacer (41) and can move in the axial direction of said first spacer (41), and
an elastic member (48) which is attached between said first and second spacers (41, 42), and
said first and second spacers (41, 42) provided with through holes (46) of the same inside diameter in the axial directions.

2. The connecting system of circuit boards according to claim 1, wherein
said first spacer (41) is provided with a holding hole (47) which holds said second spacer (42), and
said elastic member (48) is inserted into said holding hole (47) in a state abutting against the other end of said second spacer (42).

3. The connecting system of circuit boards according to claim 2, wherein said elastic member (48) is provided with a space which connects the through holes (46) at said first and second spacers (41, 42).

4. The connecting system of circuit boards according to claim 1, wherein
said first and second tapered holes (17, 27) are provided with the same taper angles,
the portions of said first and second spacers (51, 52) except said tapered parts (53, 54) are provided with the same outside diameters,
said second spacer (52) is provided at said first spacer (51) side with a reduced diameter rod part (52A),
said first spacer (51) is provided with a holding hole (57) which holds said rod part (52A), and
said elastic member (58) is attached to the outside of said rod part (52A).

5. The connecting system of circuit boards according to any one of claims 1 to 4, wherein
the through hole (46 and 56) at said first spacer (41 and 51) is formed with a thread (45 and 55) at its inner circumferential part.

6. The connecting system of circuit boards according to claim 5, wherein
said first spacer (41 and 51) is fastened to said first circuit board (20) by a first screw (8S) which engages with said thread (45 and 55) from an opposite side of said first circuit board (20) after said tapered part (43 and 53) is inserted to said first tapered hole (17) which is provided at said first circuit board (20), and
said second circuit board (21) is fastened to said first spacer (41 and 51) by a second screw (8L) which is provided with a length whereby the front end part engages with said thread (45 and 55) from an opposite side of said second circuit board (21) after said second tapered hole (27) is fit over said first tapered part (44 and 54) of said second spacer (42 and 52) in a state where external force causes said elastic member (48 and 58) to contract and said second spacer (42 and 52) to move to said first spacer (41 and 51) side.

7. The connecting system of circuit boards according to claim 6, wherein
the distance between said first and second circuit boards (20 and 21) can be changed by changing the length by which the second screw (8L) engages with said thread (45 and 55).

8. The connecting system of circuit boards according to claim 7, wherein
the distance between said first and second circuit boards (20 and 21) is determined by the total length of a stack connector (6) which is attached between the first and second circuit boards (20 and 21), and the length of said first spacer (41 and 51) other than said tapered part (43 and 53) is formed to the same length as the total length of said stack connector (6).

9. The connecting system of circuit boards according to any one of claims 1 to 8, wherein
said tapered hole (17 and 27) is provided with a bottom hole (18).

10. The connecting system of circuit boards according to any one of claims 1 to 9, wherein
two locations between said first and second circuit boards (20 and 21) are formed with said first and second tapered holes (17 and 27),
said two locations of first and second tapered holes (17 and 27) are provided with two elastic spacers (40 and 50) which are respectively attached to them.

11. The connecting system of circuit boards according to any one of claims 1 to 10, wherein
when connecting three or more circuit boards (20, 21, and 29) in parallel, each facing pair of circuit boards is provided with said first and second tapered holes (17 and 27), each of said first and second tapered holes (17 and 27) is provided with said elastic spacer (40 and 50), and said first and second tapered holes (17 and 27) are arranged so as not to overlap in position.
